# EUROPÄISCHE PATENTSCHRIFT

(11) **EP 4 344 518 B1**
(45) Veröffentlichungstag und Bekanntmachung des Hinweises auf die Patenterteilung: **14.05.2025**
(21) Anmeldenummer: 22734893.5
(22) Anmeldetag: 08.06.2022
(51) Int. Cl.: H05K 7/20

(54) **LEBENSDAUEROPTIMIERTE KÜHLUNG VON HALBLEITERN**
SERVICE LIFE-OPTIMIZED SEMICONDUCTOR COOLING
REFROIDISSEMENT OPTIMISÉ AU NIVEAU DE LA DURÉE DE VIE DES SEMI-CONDUCTEURS

(30) Priorität: 17.08.2021 EP 21191731
(43) Veröffentlichungstag der Anmeldung: 03.04.2024
(73) Patentinhaber: Siemens Aktiengesellschaft, 80333 München (DE)
(72) Erfinder: KIMPEL, Jürgen, 91052 Erlangen (DE); ROPPELT, Bernd, 96173 Unterhaid (DE); SCHMENGER, Jens, 91301 Forchheim (DE); SCHWINN, Thomas, 91074 Herzogenaurach (DE)
(74) Vertreter: Siemens Patent Attorneys
(86) Internationale Anmeldenummer: PCT/EP2022/065503
(87) Internationale Veröffentlichungsnummer: WO 2023/020729

(56) Entgegenhaltungen:
- EP-A1- 3 411 887
- EP-B1- 3 411 887
- DE-A1- 102009 042 631
- DE-A1- 102017 200 088
- DE-A1- 102019 100 438
- KR-A- 20190 092 172

## Beschreibung

Die Erfindung betrifft ein Verfahren zur Kühlung mindestens eines Halbleiters. Ferner betrifft die Erfindung eine Leistungseinheit mit mindestens einem Halbleiter, einer Kühlvorrichtung zur Kühlung des mindestens einen Halbleiters und einer Steuereinheit, wobei die Kühlleistung der Kühlvorrichtung steuerbar ist. Die Erfindung betrifft weiter einen Stromrichter mit mindestens einer derartigen Leistungseinheit.

Die Kühlung von Halbleitern hat die Aufgabe, die im Betrieb entstehende Wärme aufgrund von elektrischen Verlusten von den Halbleitern abzuführen. Ziel ist es dabei, dass im Betrieb der Halbleiter innerhalb seine zulässigen Temperaturwerte betrieben wird. Ein typischer Wert für einen Temperaturgrenzwert stellt die Sperrschichttemperatur des Halbleiters dar, der nicht überschritten werden darf, da sonst die Gefahr des Ausfalls des Ausfalls besteht, bei dem der Halbleiter zerstört werden kann.

Zur Überwachung wird meist ein Temperaturmesswert herangezogen. Da die Sperrschichttemperatur nicht ohne weiteres auf einfachem Wege messbar ist, wird eine Temperaturgrenze für eine gemessene Temperatur umgerechnet. Alternativ gibt es die Möglichkeit, mit Hilfe eines Temperaturmodells die Sperrschichttemperatur aus der gemessenen Temperatur zu errechnen.

Übersteigt die gemessene Temperatur den umgerechneten Temperaturgrenzwert oder die über das Temperaturmodell ermittelte Sperrschichttemperatur den Grenzwert für die Sperrschichttemperatur, so wird eine Schutzreaktion wie beispielsweise eine Leistungsreduktion oder ein Abschalten der Halbleiter oder des damit aufgebauten Stromrichters ausgelöst.

Zum Teil werden heute Halbleiter und daraus aufgebaute Stromrichter mit einer Überdimensionierung ausgelegt, um ein Überschreiten von Grenzwerten zu verhindern und eine hohe Lebensdauer sicherzustellen. Dies führt häufig zu überdimensionierten Halbleiterchips in den Halbleitern. Darüber hinaus wird ein worst case Szenario für die Auslegung verwendet, das sicherstellt, dass die Temperaturgrenzen unter den zulässigen Betriebsbedingungen eingehalten werden können.

Ein Halbleiter ist während seines Betriebs unter anderem durch die entstehenden Temperaturen, einer Belastung unterworfen. Der zeitliche Verlauf der Belastung wird auch als Lastspiel bezeichnet. Insbesondere wird dieser zeitliche Verlauf auch als Lastspiel bezeichnet, wenn diese Belastung zyklisch, also wiederkehrend, erfolgt.

Aus der DE 10 2017 200088 A1 ist ein Verfahren zum Klimatisieren einer Komponente einer leistungselektronischen Schaltung, wie beispielsweise eines Inverters bekannt.

Des Weiteren ist aus der DE 10 2019 100438 A1 ein Temperatursteuerungssystem für ein elektronisches Traktionsleistungssystem eines elektrischen Hybridfahrzeugs bekannt, welches mit einer Steuerung, die so konfiguriert ist, dass sie die Pumpe mit einer vordefinierten Geschwindigkeit oder mit einer Geschwindigkeit, die auf der Differenz zwischen der Temperatur und der Temperatur des Kühlmittels basiert, betreibt.

Der Erfindung liegt die Aufgabe zugrunde, die Kühlung von Halbleitern zu verbessern.

Diese Aufgabe wird durch ein Verfahren zur Kühlung mindestens eines Halbleiters mit den Merkmalen des Anspruchs 1 gelöst. Ferner wird diese Aufgabe durch eine Leistungseinheit, aufweisend mindestens einen Halbleiter, eine Kühlvorrichtung zur Kühlung des mindestens einen Halbleiters und eine Steuereinheit gelöst, wobei die Kühlleistung der Kühlvorrichtung steuerbar ist, wobei die Steuereinheit eingerichtet ist, die Kühlleistung der Kühlvorrichtung mittels eines derartigen Verfahrens zu steuern oder zu regeln. Weiter wird diese Aufgabe durch einen Stromrichter mit mindestens einer derartigen Leistungseinheit gelöst.

Weitere vorteilhafte Ausgestaltungen der Erfindung sind in den abhängigen Ansprüchen angegeben.

Der Erfindung liegt unter anderem die Erkenntnis zugrunde, dass sich die Lebensdauer eines Halbleiters, einer Leistungseinheit und/oder eines Stromrichters verlängern lässt, wenn die Kühlung der Halbleiter veränderbar ist und diese in Abhängigkeit von einem Lastspiel des Halbleiters gesteuert oder geregelt wird. Es hat sich herausgestellt, dass bei Halbleitern, insbesondere bei Leistungshalbleitern wie IGBT-Modulen, der Chip-Temperaturhub aufgrund der internen Aufbautechnik, ein wesentlicher begrenzender Parameter für die Lebensdauer und die Auslegung des Halbleiters ist. Eine Reduzierung der Temperaturhübe über das Lastspiel führt zu einer Verlängerung der Lebensdauer und somit zu einer Verbesserung der Kühlung.

Dabei wird die Belastung des Halbleiters über eine vorgebbare Zeitdauer bestimmt. Aus dieser bestimmten Belastung ergibt sich dann das für die Regelung oder Steuerung zugrunde gelegte Lastspiel.

Dazu wertet in vorteilhafter Weise die Steuereinheit die Lastspiele des Halbleiters, der Leistungseinheit oder des Stromrichters aus. Das kann beispielsweise anhand der Ströme, der Leistungen, Verlustleistungen, Temperaturen oder anderen erfassten oder berechneten Größen geschehen. Mit der Kenntnis über das Lastspiel oder die Lastspiele kann beispielsweise die Kühlkörpertemperatur in der Umgebung eines oder mehrerer Halbleiter beeinflusst werden. Dies wirkt sich dann auch auf die Temperatur des Halbleiters aus. Zur Steuerung der Kühlkörpertemperatur kann bei einer Luftkühlung beispielsweise die Lüfterdrehzahl verändert werden. Bei einer Flüssigkeitskühlung kann beispielsweise die Durchflussmenge oder die Temperatur der Kühlflüssigkeit zur Steuerung oder Regelung der Kühlvorrichtung verwendet werden. Die Regelung oder Steuerung des Kühlmediums kann sich dadurch positiv auf die Lebensdauer des Halbleiters auswirken, wenn durch die Steuerung oder Regelung eine stetigere Kühlkörpertemperatur erreicht wird und sich dadurch der Temperaturhub am Halbleiter oder die Geschwindigkeit der Temperaturänderung am Halbleiter reduziert. Auch kann die Regelung oder Steuerung der Kühlvorrichtung alternativ oder ergänzend dazu genutzt werden, die Anzahl der Temperaturhübe am Halbleiter zu reduzieren. Dazu kann beispielsweise die Lüfterdrehzahl bei einer Überlast des Halbleiters nicht nur erhöht oder sogar deutlich, beispielsweise auf einen Maximalwert, erhöht werden, um einem Temperaturanstieg insbesondere des Kühlkörpers oder des Halbleiters entgegenzuwirken, sondern es hat sich darüber hinaus als sinnvoll erwiesen, bei geringer Belastung des Halbleiters die Lüfterdrehzahl zu verringern, um ein zu starkes Abkühlen des Kühlkörpers oder des Halbleiters zu vermeiden. Damit wird erreicht, dass die Temperatur am Kühlkörper oder am Halbleiter möglichst konstant gehalten wird, um damit die Schwankungsbreite der Temperaturhübe zu verkleinern und/oder die Anzahl der Temperaturhübe zu verringern.

Die Steuerung oder Regelung der Kühlkörpertemperatur mit ihrem Einfluss auf die Halbleitertemperatur wird bei einem Kühlkörper mit Zwangskonvektion besonders effizient über die Variation der Lüfterregelung durchgeführt. Dabei können als weitere Eingangsgrößen für die Regelung oder Steuerung der Kühlvorrichtung der Strom, insbesondere der Iststrom, durch den Halbleiter, die Zwischenkreisspannung des Stromrichters und/oder die Ausgangsfrequenz des Stromrichters berücksichtigt werden. Damit wird nicht nur eine lange Lebensdauer erreicht, sondern die Kühlung kann auch den aktuellen Betriebszustand des Halbleiters oder des Stromrichters berücksichtigen und damit eine Kühlung erzeugen, die nicht nur lebensdauerverlängernd wirkt, sondern auch den augenblicklichen Betriebszustand berücksichtigt, und damit vor kurzzeitiger Überlastung schützt.

Mit den Informationen aus dem Lastspiel, das durch die Steuereinheit erkannt und ausgewertet wird, kann eine Vorsteuerung der Temperatur des Kühlkörpers oder des Halbleiters über die Lüfterdrehzahl beispielsweise nach einem erkanntem Lastspielmuster erfolgen und somit der Kühlkörper auf einer relativ konstanten Temperatur gehalten werden. Diese möglichst konstante Temperatur weist eine nur geringe Schwankungsbreite der Temperaturhübe auf. Sonst vorkommende Temperaturhübe können sogar ganz entfallen, so dass sich auch die Anzahl der Temperaturhübe reduziert. Dies bedingt einen geringeren Temperaturhub am Halbleiter, insbesondere bei der Sperrschichttemperatur sowie eine geringere Anzahl von Temperaturhüben. Sowohl die geringere Schwankungsbreite als auch die geringere Anzahl an Temperaturhüben führt zu einer längeren Lebensdauer der Halbleiter und damit auch zu einer längeren Lebensdauer der daraus aufgebauten Geräte wie beispielsweise eines Stromrichters.

Der Vorteil wirkt sich besonders günstig bei längeren Lastspielen aus, deren Überlast oder Überlasten in einer Zeitdauer im Bereich von 1 bis 5 Minuten liegen. Diese Zeitdauer ist dabei abhängig von den thermischen Eigenschaften des eingesetzten Kühlkörpers, wie beispielsweise seiner der thermischen Masse.

Eine weitere Anwendung ist die gezielte Vorsteuerung der Kühlung bei kurzen Lastspielen im Bereich von 5 bis 20s, die keine großen Spitzen in den Verlustleistungen generieren. In diesen Zeiten kann die Lüfterdrehzahl erhöht werden, um die Kühlkörpertemperatur abzusenken, ohne dass dabei Temperaturhübe aufgrund von Verlustleistungsspitzen im Halbleiter erzeugt werden. Die niedrigere Kühlkörpertemperatur und folgend die niedrigere Temperatur des Halbleiters führen zu einer höheren Lebensdauer des Halbleiters. Besonders positiv wirkt dieser Effekt bei Leistungshalbleitern wie beispielsweise einem IGBT-Modul.

Durch das gezielte Vorsteuern der Temperatur des Kühlkörpers oder des Halbleiters kann bei Überlasten und folglich hohen Kühlkörpertemperaturen einer Leistungsreduktion aufgrund von kurzfristigen Leistungsspitzen und damit einhergehenden Temperatur gezielt entgegengewirkt werden, da die entsprechenden Komponenten oder das Gerät nicht ins Derating geht.

Somit hat es sich als vorteilhaft erwiesen, bei Pulsfreigabe des Stromrichters den Lüfter in Abhängigkeit des Lastspiels, insbesondere auf Basis des erkannten, sich wiederholenden Lastspiels, beispielsweise in Abhängigkeit von der gemessenen und/oder ausgewerteten Kühlkörpertemperatur oder Halbleitertemperatur vorzusteuern und zu betrieben. Im Gegensatz zu einem Betrieb mit Nenndrehzahl können somit die Temperaturhübe verkleinert werden. Dadurch ergeben sich eine höhere Lebensdauer des Halbleiters, insbesondere bei einem Leistungsmodul wie einem IGBT-Modul. Diese Module definieren meist die Lebensdauer der daraus aufgebauten Geräte wie beispielsweise eines Stromrichters. Gleichzeitig ermöglicht die Anwendung des vorgeschlagenen Verfahrens eine höhere Ausnutzung der Geräte und demzufolge der zugehörigen Anlagen. Durch die reduzierte Kühlleistung kann zudem eine Energieeinsparung bei der Kühlvorrichtung erreicht werden. Denn die mittlere Kühlkörpertemperatur kann in Abhängigkeit des gefahrenen Lastspiels gegebenenfalls höher ausfallen, ohne sich negativ auf die Lebensdauer auszuwirken.

Bei einer vorteilhaften Ausgestaltung der Erfindung wird der Strom durch den Halbleiter gemessen, wobei aus dem Strom durch den Halbleiter und der Schaltfrequenz des Halbleiters die Belastung des Halbleiters ermittelt wird. Wesentliche Verlustfaktoren des Halbleiters ergeben sich aus der Summe von Durchlassverlusten und Schaltverlusten. Die Durchlassverluste können linear in Abhängigkeit des Stromes und/oder als Quadrat des Stromes bestimmt werden. Die Schaltverluste können dem Datenblatt in Abhängigkeit von der Schaltfrequenz in der Steuereinheit des Halbleiters hinterlegt werden und stehen für die Berechnung dann zur Verfügung. Alternativ ist es auch möglich, die Schaltverluste dadurch zu bestimmen, dass diese identisch den Durchlassverlusten angenommen werden. Es hat sich bei der Auslegung von Halbleitern für den bestimmungsgemäßen Betrieb als sinnvoll erwiesen, den Halbleiter derart zu betreiben, dass Durchlassverluste und Schaltverluste über einen weiten Arbeitsbereich identisch sind.

Im Rahmen der Erfindung wird die Kühlvorrichtung in Abhängigkeit von der über die vorgebbare Zeitdauer gemittelten Belastung gesteuert oder geregelt wird. Die Mittelung der Belastung des Stromrichters hat den Vorteil, dass sich die Kühlleistung nur moderat ändert. Da die Änderung der Kühlleistung oftmals auch mit einer Änderung von Geräuschen einhergeht, kann die Geräuschentwicklung angenehmer gestaltet werden. Dies erhöht die Kundenakzeptanz einer aus dieser Leistungseinheit aufgebauten elektrischen Komponente wie beispielsweise einem Stromrichter. Dadurch lassen sich die Verkaufschancen und damit auch die Verkaufszahlen erhöhen. Zudem ist eine derartige Komponente aufgrund der optimierten Geräuschentwicklung umweltfreundlicher.

Bei einer weiteren vorteilhaften Ausgestaltung der Erfindung wird die Kühlvorrichtung derart gesteuert, dass sich die Schwankungsbreite einer Temperaturschwankung am Halbleiter reduziert. Als eine besonders wirksame Methode, die Lebensdauer zu verlängert, hat sich herausgestellt, die Schwankungsbreite der Temperaturschwankung zu reduzieren. Dies kann dadurch geschehen, dass bei einer Abweichung der Halbleitertemperatur von einem Zielwert, die Kühlung verstärkt wird, insbesondere deutlich verstärkt wird, wenn die Halbleitertemperatur nach oben vom Zielwert abweicht. Andernfalls, bei einer Abweichung der Halbleitertemperatur nach unten, kann die Kühlung deutlich reduziert werden. Bei einer Auswertung des Lastspiels und damit bekannten zukünftigen Lastverhalten, kann die Regelung oder Steuerung derart eingreifen, dass die Temperatur bei Einhalten des prognostizierten Lastverhaltens konstant oder zumindest nahezu konstant bleibt.

Bei einer weiteren vorteilhaften Ausgestaltung der Erfindung wird aus dem Lastspiel ein Referenzwert ermittelt, wobei in Abhängigkeit von der Differenz aus der augenblicklichen Belastung des Halbleiters und dem Referenzwert die Kühlleistung der Kühlvorrichtung gesteuert wird. Der Referenzwert eignet sich, einen Zielwert für die Erwärmung des Halbleiters oder des Kühlkörpers zu ermitteln. Der Referenzwert kann dabei ein Mittelwert aus dem Lastspiel und somit beispielsweise eine mittlere Last darstellen. Der Referenzwert stellt dabei beispielsweise die über eine bestimmte Zeit gemittelte Last dar. Die Halbleitertemperatur kann dann als Zielwert eine Temperatur annehmen, die sich bei konstanter Belastung mit der mittleren Last ergibt. Bei Abweichung der Last im Lastspiel von der mittleren Last wird die Leistung der Kühlvorrichtung derart geändert, dass sich die Temperatur nur geringfügig ändert. Also bei einer höheren augenblicklichen Belastung als die mittlere Belastung wird die Kühlleistung verstärkt, ansonsten reduziert. So ergibt sich eine besonders geringe Schwankungsbreite der Halbleitertemperaturschwankung. Dies führt zu einem hohen Gewinn an Lebensdauer für den Halbleiter.

Bei einem periodischen Lastspiel bietet sich als Referenzwert dabei eine Mittelwertbildung der Belastung an, die über die Periodendauer des Lastspiels gemittelt wird. Dadurch ergibt sich ein besonders genauer Zielwert für die Temperatur des Halbleiters oder des Kühlkörpers mit einer besonders geringen Schwankungsbreite dieser Temperatur. Dies hat eine besonders hohe Lebensdauer zur Folge.

Ist jedoch das Lastspiel nicht periodisch oder weist Anteile mit unterschiedlichen Periodendauern auf oder ist die Periodendauer nicht bekannt oder nicht ermittelbar, dann bietet sich eine Glättung der Belastung an, um zu beurteilen, ob sich der Halbleiter in einer höheren Belastungsphase befindet. Der Referenzwert kann in diesem Fall durch Glättung der Belastung ermittelt werden. Dies kann beispielsweise mit einem PT1 Glied geschehen. Für unbekannte Belastung, sich ändernde Belastungen oder nicht periodische Belastungen steht mit der Glättung ein wirksames Instrument bereit, die Schwankungsbreite der Temperaturschwankungen zu verringern und eine hohe Lebensdauer der Halbleiter sicherzustellen.

Bei einer weiteren vorteilhaften Ausgestaltung der Erfindung wird bei positiver Differenz aus der augenblicklichen Belastung des Halbleiters und dem Referenzwert die Kühlleistung der Kühlvorrichtung erhöht und bei negativer Differenz aus der augenblicklichen Belastung des Halbleiters und dem Referenzwert die Kühlleistung der Kühlvorrichtung mit einer vorgegebenen Änderungsgeschwindigkeit reduziert. Eine derartige Reaktion hält die Schwankungsbreite der Temperaturschwankung gering und ist besonders einfach durch bekannte Regler wie beispielsweise einem Regler mit P-Anteil umsetzbar. Dieser Regler kann auch um einen I-Anteil und/oder einen D-Anteil erweitert werden. Eine derartige Regelung ist einfach und wirkungsvoll in einer Steuereinrichtung einsetzbar mit der sich eine Erhöhung der Lebensdauer erreichen lässt.

Die vorgegebene Änderungsgeschwindigkeit gibt die Möglichkeit, langsam auf eine geringere Kühlungsanforderung zu reagieren. Da sich diese nicht negativ auf die Lebensdauer auswirkt, kann diese so gewählt werden, dass die Änderung nur langsam erfolgt. Da meist mit der Kühlung abhängig von der Kühlleistung eine Geräuschentstehung verbunden ist, kann die Änderung der Geräusche reduziert werden. Dies wird oftmals als angenehmer empfunden als plötzliche oder schlagartige Änderungen in der Geräuschentwicklung. Dies erhöht die Akzeptanz beim Anwender und erhöht die Verkaufschancen und damit die verkauften Stückzahlen. Dieser Effekt macht sich insbesondere bei der Luftkühlung besonders stark bemerkbar, da der Luftstrom eine Geräuschentwicklung verursachen kann.

Bei einer weiteren vorteilhaften Ausgestaltung der Erfindung wird der Referenzwert aus einer Mittelwertbildung, insbesondere einer gewichteten Mittelwertbildung, oder aus einer Glättung der augenblicklichen Belastung ermittelt. Wie bereits beschreiben ist die Bildung des Referenzwertes für ein periodisches Lastspiel besonders wirksam, da sich dadurch die Schwankungsbreite der Temperaturschwankung im hohen Maße reduzieren lässt. Wenn jedoch die Periodendauer nicht bekannt oder ermittelbar ist oder das Lastspiel nicht periodisch ist oder sich häufig ändert, ist die Bildung des Referenzwertes durch Glättung der Belastung, beispielsweise mittels eines PT1 Gliedes eine besonders wirksame Methode, die Schwankungsbreite der Temperaturschwankung gering zu halten und eine hohe Lebensdauer zu erzielen.

Bei einer weiteren vorteilhaften Ausgestaltung der Erfindung erfolgt bei einem sich wiederholendem Lastspiel eine Mittelwertbildung über die Periodendauer der wiederholenden Belastung oder die Glättung mit einer Zeitkonstante im Bereich der Periodendauer. Sich wiederholende Lastspiele haben den Vorteil, dass sich das zukünftige Verhalten besonders genau vorhersagen lässt. Daher kann die Mittelwertbildung über die Periodendauer des periodischen Lastspiels oder die Glättung mit einer Zeitkonstanten in der Größenordnung der Periodendauer durchgeführt werden. Dadurch ist die Schwankungsbreite besonders gering und die Lebensdauer besonders hoch.

Bei einer weiteren vorteilhaften Ausgestaltung der Erfindung ist die Kühlvorrichtung als Luftkühlung ausgebildet und die Erhöhung der Kühlleistung erfolgt durch eine Erhöhung einer Lüfterdrehzahl. Die Erhöhung der Lüfterdrehzahl ist bei einer Luftkühlung besonders einfach realisierbar und stellt gleichzeitig eine hocheffektive Möglichkeit der Beeinflussung der Kühlvorrichtung dar. Die Stellgröße benötigt wenig Energie für die Steuerung oder Regelung der Kühlvorrichtung, so dass diese effizient und mit wenig Energieaufwand arbeitet und gleichzeitig eine hohe Lebensdauer erzielen lässt.

Bei einer weiteren vorteilhaften Ausgestaltung der Erfindung ist die Kühlvorrichtung als Flüssigkeitskühlung ausgebildet und die Erhöhung der Kühlleistung erfolgt durch eine Erhöhung eines Kühlmitteldurchsatzes und/oder durch die Reduktion der Temperatur der Kühlflüssigkeit. Die Erhöhung des Kühlmitteldurchsatzes oder die Reduktion der Kühlmitteltemperatur ist bei einer Flüssigkeitskühlung besonders einfach realisierbar und stellt gleichzeitig eine hocheffektive Möglichkeit der Beeinflussung der Kühlvorrichtung dar. Die Stellgröße benötigt wenig Energie für die Steuerung oder Regelung der Kühlvorrichtung, so dass diese effizient und mit wenig Energieaufwand arbeitet und gleichzeitig eine hohe Lebensdauer erzielen lässt.

Bei einer weiteren vorteilhaften Ausgestaltung der Erfindung wird aus dem Lastspiel die minimale und die maximale Belastung des Halbleiters ermittelt, wobei die Kühlleistung im Bereich von 0 bis 20% der Nennkühlleistung gesteuert wird, wenn die augenblickliche Belastung des Halbleiters die minimale Belastung erreicht und die Kühlleistung im Bereich von 100 bis 200% der Nennkühlleistung gesteuert wird, wenn die augenblickliche Belastung des Halbleiters die maximale Belastung erreicht. Hierdurch wird erreicht, dass für die Beeinflussung der Temperaturschwankung am Halbleiter und/oder Kühlkörper eine hohe Stellreserve zur Verfügung steht und einer Änderung der Temperatur entgegenwirkt. Die maximale Stellreserve, optional abzüglich eines Sicherheitsabstandes, wird derart genutzt, dass sie für die maximale und minimale Abweichung vom Referenzwert auch die maximale Stellreserve eingesetzt wird. Dadurch lassen sich die Schwankungsbreite der Temperatur besonders geringhalten und teilweise Temperaturschwankung bereits vollkommen eliminieren.

Bei einer weiteren vorteilhaften Ausgestaltung der Erfindung wird aus dem Lastspiel eine zukünftige Belastung der Halbleiter ermittelt, wobei vor Auftreten einer ansteigenden Belastung, die anhand der ermittelten zukünftigen Belastung erkannt wird, die Kühlleistung der Kühlvorrichtung erhöht wird. Gerade bei periodischen Lastspielen oder wiederkehrenden Lastspielen lässt sich eine zukünftige Belastung berechnen, bestimmen oder zumindest abschätzen. Aus dieser zukünftigen Belastung kann auch das zukünftige Temperaturverhalten bestimmt werden. Durch Einflussnahme auf die Kühlvorrichtung kann dieses Temperaturverhalten beeinflusst werden. Ist eine steigende zukünftige Belastung prognostiziert kann die Kühlleistung verstärkt werden. Bei abfallender zukünftiger Belastung kann die Kühlleistung reduziert werden. Da zwischen dem Eingriff der Regelvorrichtung und der Auswirkung auf die Temperatur ein gewisser Zeitverzug vorhanden ist, kann durch die Ermittlung der zukünftigen Belastung der Regeleingriff derart früh erfolgen, dass Temperaturschwankungen auch mit geringem Regeleingriff, d.h. geringen Stellgrößen, wirkungsvoll unterdrückt werden und besonders gering ausfallen. So ist eine besonders hohe Lebensdauer erzielbar.

Bei einer weiteren vorteilhaften Ausgestaltung der Erfindung wird die Kühlleistung zu einem Zeitpunkt auf einen Maximalwert gesteuert, so dass bei Auftreten der Belastung, wie sie sich aus der zuvor ermittelten zukünftigen Belastung der Halbleiter ergibt, innerhalb seines zulässigen Temperaturbereichs betrieben wird. Für den Fall hoher Belastungen in der zukünftigen Belastung kann diese Information genutzt werden, um Schutzabschaltungen zu vermeiden. Zeichnet sich eine hohe Belastung ab, die zu einem Überschreiten von Temperaturgrenzwerten beim Halbleiter führt, kann diese bereits durch die Ermittlung der kurzfristigen Belastung derart frühzeitig erkannt werden, so dass die Kühlleistung frühzeitig auf einen Maximalwert geregelt oder gesteuert wird. Dies erfolgt derart frühzeitig, dass im Kühlkörper gespeicherte Wärme an die Umgebung abgeführt wird, um dadurch eine besonders hohe Wärmemenge vom Halbleiter aufzunehmen. In diesem Fall wirkt die Regelung zwar nicht unbedingt lebensdauererhöhend, kann aber den Betrieb des Halbleiters bzw. des Stromrichters auch bei hoher Belastung oder sogar bei Überlastung aufrechterhalten. Dies führt zu einer besonders hohen Verfügbarkeit des Halbleiters oder des Stromrichters.

Bei einer weiteren vorteilhaften Ausgestaltung der Erfindung wird die Kühlleistung derart gesteuert, dass sich im Mittel eine Kühlleistung von mindestens der Nennkühlleistung, insbesondere genau der Nennkühlleistung, ergibt. Dieser Betrieb stellt sicher, dass die Kühlvorrichtung gut ausgenutzt wird und damit auch neben geringen Temperaturschwankungen die anliegende Temperatur am Halbleiter, die sich ebenfalls auf die Lebensdauer auswirkt, niedrig hält. Auch dabei handelt es sich um eine lebensdauerverlängernde Maßnahme, die gleichzeitig dazu führt, dass der Halbleiter und der Stromrichter gut ausgenutzt werden und keine oder nur geringe Überdimensionierungen aufweisen. Damit lassen sich diese Komponenten in einem günstigen Preis/Leistungsverhältnis herstellen.

Im Folgenden wird die Erfindung anhand der in den Figuren dargestellten Ausführungsbeispiele näher beschrieben und erläutert. Es zeigen:
- FIG 1: eine Leistungseinheit,
- FIG 2: einen Stromrichter und
- FIG 3: eine funktionale Darstellung der Steuereinheit.

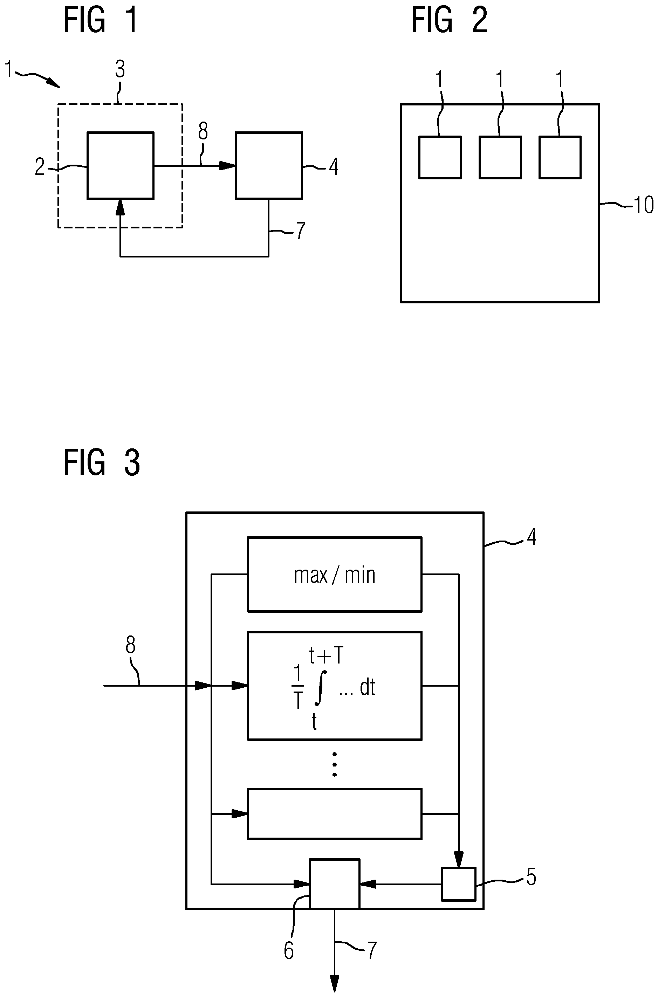

Die FIG 1 zeigt eine Leistungseinheit 1 mit einem Halbleiter 2 und einer Kühlvorrichtung 3 zur Kühlung des Halbleiters 2 und eine Steuereinheit 4. Dabei kann die Leistungseinheit 1 auch mehrere Halbleiter 2 aufweisen. Beispielsweise hat es sich bei einem Leistungseinheit 1 für einen hier nicht dargestellten Stromrichter 10 als günstig erwiesen, sechs Halbleiter 2 in einer Leistungseinheit 1 anzuordnen, wobei die sechs Halbleiter 2 eine Brückenschaltung bilden. Da die sechs Halbleiter 2 eines Stromrichters 10 die nahezu gleiche Belastung erfahren, ist es vorteilhaft, wenn diese von genau einer Kühlvorrichtung 3 gekühlt werden.

Zur Steuerung oder Regelung der Kühlvorrichtung 3 werden von dem Halbleiter 2 Messwerte 8 aufgenommen. Aus dem zeitlichen Verlauf der Messwerte 8 können Informationen zum Lastspiel entnommen werden. Das Lastspiel, das die Belastung des Halbleiters 2 widerspiegelt, wird dann zur Steuerung oder Regelung der Kühlvorrichtung 3 herangezogen. Dazu werden beispielsweise ein oder mehrere Messwerte 8 vom Halbleiter 2 durch eine Steuereinheit 4 aufgenommen und ausgewertet. Nach der Verarbeitung wird ein Ausgangssignal 7 der Steuereinheit 4 generiert und der Kühlvorrichtung 3 zugeführt, so dass die Kühlvorrichtung 3 in Abhängigkeit vom Lastspiel des Halbleiters 2 gesteuert oder geregelt wird.

Die FIG 2 zeigt einen Stromrichter 10 mit einer Vielzahl, in diesem Ausführungsbeispiel drei, Leistungseinheiten 1. Dabei können die Leistungseinheiten beispielsweise jeweils eine Phase eines dreiphasigen Stromrichters 10 bilden und somit genau zwei Halbleiter 2 aufweisen.

Die FIG 3 zeigt einen funktionalen Aufbau der Regeleinheit 4, die es ermöglicht, die hier nicht dargestellte Kühlvorrichtung 3 in Abhängigkeit des Lastspiels des Halbleiters 2 zu steuern oder zu regeln. Messwerte 8 an dem Halbleiter 2 oder dem Stromrichter 10 werden von der Auswerteeinheit 4 aufgenommen und verarbeitet. Die Verarbeitung kann dabei beispielsweise die Ermittlung von Maximal- und Minimalwerten umfassen. Darüber hinaus kann, alternativ oder ergänzend, eine Mittelwertbildung, insbesondere eine Mittelwertbildung über gewichtete Größen erfolgen. Ergänzend oder alternativ kann auch eine Glättung der Messwerte beispielsweise mit einem PT1 Glied und einer dazugehörigen Zeitkonstante erfolgen. Aus den unterschiedlichen Berechnungsmöglichkeiten wird dann ein Referenzwert 5 generiert. Dieser Referenzwert wird in einem Vergleicher mit der augenblicklichen Belastung verglichen, die sich aus den Messwerten 8 ergibt. Je nach Höhe der Abweichung der augenblicklichen Belastung vom Referenzwert wird ein Ausgangssignal 7 zur Steuerung oder Regelung der Kühlvorrichtung 3 erzeugt.

Zusammenfassend betrifft die Erfindung ein Verfahren zur Kühlung mindestens eines Halbleiters. Zur Verbesserung der Kühlung im Hinblick auf die Lebensdauer des Halbleiters wird vorgeschlagen, dass in Abhängigkeit von einem Lastspiel des Halbleiters eine Kühlvorrichtung zur Kühlung des mindestens einen Halbleiters gesteuert wird. Konkret wird dabei zur Verbesserung der Kühlung im Hinblick auf die Lebensdauer des Halbleiters vorgeschlagen, dass der zeitliche Verlauf der Belastung des Halbleiters über eine vorgebbare Zeitdauer bestimmt wird, wobei in Abhängigkeit von einem Lastspiel, die sich aus dem bestimmten zeitlichen Verlauf der Belastung ergibt, des Halbleiters 2 eine Kühlvorrichtung 3 zur Kühlung des mindestens einen Halbleiters 2 gesteuert oder geregelt wird. Die Erfindung betrifft weiter eine Leistungseinheit, aufweisend mindestens einen Halbleiter, eine Kühlvorrichtung zur Kühlung des mindestens einen Halbleiters und eine Steuereinheit, wobei die Kühlleistung der Kühlvorrichtung steuerbar ist, wobei die Steuereinheit eingerichtet ist, die Kühlleistung der Kühlvorrichtung mittels eines derartigen Verfahrens zu steuern oder zu regeln. Ferner betrifft die Erfindung einen Stromrichter mit mindestens einer derartigen Leistungseinheit.

## Patentansprüche

1. Verfahren zur Kühlung mindestens eines Halbleiters (2), wobei der zeitliche Verlauf der Belastung des Halbleiters über eine vorgebbare Zeitdauer bestimmt wird, wobei in Abhängigkeit von einem Lastspiel des Halbleiters (2), die sich aus dem bestimmten zeitlichen Verlauf der Belastung ergibt, eine Kühlvorrichtung (3) zur Kühlung des mindestens einen Halbleiters (2) gesteuert oder geregelt wird, **dadurch gekennzeichnet, dass** die Kühlvorrichtung (3) in Abhängigkeit von der über die vorgebbare Zeitdauer gemittelten Belastung gesteuert oder geregelt wird.

2. Verfahren nach Anspruch 1, wobei der Strom durch den Halbleiter (2) gemessen wird, wobei aus dem Strom durch den Halbleiter (2) und der Schaltfrequenz des Halbleiters (2) die Belastung des Halbleiters (2) ermittelt wird.

3. Verfahren nach einem der Ansprüche 1 oder 2, wobei die Kühlvorrichtung (3) derart gesteuert wird, dass sich die Schwankungsbreite einer Temperaturschwankung am Halbleiter (2) reduziert.

4. Verfahren nach einem der Ansprüche 1 bis 3, wobei aus dem Lastspiel ein Referenzwert (5) ermittelt wird, wobei in Abhängigkeit von der Differenz aus der augenblicklichen Belastung des Halbleiters (2) und dem Referenzwert (5) die Kühlleistung der Kühlvorrichtung (3) gesteuert wird.

5. Verfahren nach Anspruch 4, wobei bei positiver Differenz aus der augenblicklichen Belastung des Halbleiters (2) und dem Referenzwert (5) die Kühlleistung der Kühlvorrichtung erhöht wird und bei negativer Differenz aus der augenblicklichen Belastung des Halbleiters (2) und dem Referenzwert (5) die Kühlleistung der Kühlvorrichtung (3) mit einer vorgegebenen Änderungsgeschwindigkeit reduziert wird.

6. Verfahren nach einem der Ansprüche 4 oder 5, wobei der Referenzwert (5) aus einer Mittelwertbildung, insbesondere einer gewichteten Mittelwertbildung, oder aus einer Glättung der augenblicklichen Belastung ermittelt wird.

7. Verfahren nach Anspruch 6, wobei bei einem sich wiederholendem Lastspiel eine Mittelwertbildung über die Periodendauer der wiederholenden Belastung oder die Glättung mit einer Zeitkonstante im Bereich der Periodendauer erfolgt.

8. Verfahren nach einem der Ansprüche 1 bis 7, wobei die Kühlvorrichtung (3) als Luftkühlung ausgebildet ist und die Erhöhung der Kühlleistung durch eine Erhöhung einer Lüfterdrehzahl erfolgt.

9. Verfahren nach einem der Ansprüche 1 bis 7, wobei die Kühlvorrichtung (3) als Flüssigkeitskühlung ausgebildet ist und die Erhöhung der Kühlleistung durch eine Erhöhung eines Kühlmitteldurchsatzes und/oder durch eine Reduktion der Temperatur der Kühlflüssigkeit erfolgt.

10. Verfahren nach einem der Ansprüche 1 bis 9, wobei aus dem Lastspiel die minimale und die maximale Belastung des Halbleiters (2) ermittelt wird, wobei die Kühlleistung im Bereich von 0 bis 20% der Nennkühlleistung gesteuert wird, wenn die augenblickliche Belastung des Halbleiters (2) die minimale Belastung erreicht und die Kühlleistung im Bereich von 100 bis 200% der Nennkühlleistung gesteuert wird, wenn die augenblickliche Belastung des Halbleiters (2) die maximale Belastung erreicht.

11. Verfahren nach einem der Ansprüche 1 bis 10, wobei aus dem Lastspiel eine zukünftige Belastung der Halbleiter (2) ermittelt wird, wobei vor Auftreten einer ansteigenden Belastung, die anhand der ermittelten zukünftigen Belastung erkannt wird, die Kühlleistung der Kühlvorrichtung (3) erhöht wird.

12. Verfahren nach Anspruch 11, wobei die Kühlleistung zu einem Zeitpunkt auf einen Maximalwert gesteuert wird, so dass bei Auftreten der Belastung, wie sie sich aus der zuvor ermittelten zukünftigen Belastung der Halbleiter (2) ergibt, innerhalb seines zulässigen Temperaturbereichs betrieben wird.

13. Verfahren nach einem der Ansprüche 1 bis 12, wobei die Kühlleistung derart gesteuert wird, dass sich im Mittel eine Kühlleistung von mindestens der Nennkühlleistung, insbesondere genau der Nennkühlleistung, ergibt.

14. Leistungseinheit (1), aufweisend
- mindestens einen Halbleiter (2),
- eine Kühlvorrichtung (3) zur Kühlung des mindestens einen Halbleiters (2) und
- eine Steuereinheit (4),
wobei die Kühlleistung der Kühlvorrichtung (3) steuerbar ist, **dadurch gekennzeichnet, dass** die Steuereinheit (4) eingerichtet ist, die Kühlleistung der Kühlvorrichtung (3) mittels eines Verfahrens nach einem der Ansprüche 1 bis 13 zu steuern oder zu regeln.

15. Stromrichter (10) mit mindestens einer Leistungseinheit (1) nach Anspruch 14.

## Claims

1. Method for cooling at least one semiconductor (2), wherein the time profile of the load of the semiconductor is determined over a predefinable period of time, wherein depending on a load cycle of the semiconductor (2) resulting from the determined time profile of the load, a cooling apparatus (3) for cooling the at least one semiconductor (2) is controlled or regulated, **characterised in that** the cooling apparatus (3) is controlled or regulated as a function of the load averaged over the predefinable period of time.

2. Method according to claim 1, wherein the current through the semiconductor (2) is measured, wherein the load on the semiconductor (2) is determined from the current through the semiconductor (2) and the switching frequency of the semiconductor (2).

3. Method according to one of claims 1 or 2, wherein the cooling apparatus (3) is controlled in such a way that the fluctuation range of a temperature fluctuation on the semiconductor (2) is reduced.

4. Method according to one of claims 1 to 3, wherein a reference value (5) is ascertained from the load cycle, wherein the cooling power of the cooling apparatus (3) is controlled as a function of the difference between the instantaneous load on the semiconductor (2) and the reference value (5).

5. Method according to claim 4, wherein in the case of a positive difference between the instantaneous load of the semiconductor (2) and the reference value (5), the cooling power of the cooling apparatus is increased and in the case of a negative difference between the instantaneous load of the semiconductor (2) and the reference value (5), the cooling power of the cooling apparatus (3) is reduced at a predetermined rate of change.

6. Method according to one of claims 4 or 5, wherein the reference value (5) is ascertained from a mean value formation, in particular a weighted mean value formation, or from a smoothing of the instantaneous load.

7. Method according to claim 6, wherein in the case of a recurring load cycle, a mean value formation takes place over the period of the recurring load or the smoothing takes place with a time constant in the region of the period.

8. Method according to one of claims 1 to 7, wherein the cooling apparatus (3) is designed as air cooling and the cooling power is increased by increasing a fan speed.

9. Method according to one of claims 1 to 7, wherein the cooling apparatus (3) is designed as liquid cooling and the cooling power is increased by increasing a cooling medium flow rate and/or by reducing the temperature of the cooling medium.

10. Method according to one of claims 1 to 9, wherein the minimum and the maximum load of the semiconductor (2) is ascertained from the load cycle, wherein the cooling power is controlled in the range of 0 to 20% of the nominal cooling capacity when the instantaneous load of the semiconductor (2) reaches the minimum load and the cooling power is controlled in the range of 100 to 200% of the nominal cooling capacity when the instantaneous load of the semiconductor (2) reaches the maximum load.

11. Method according to one of claims 1 to 10, wherein a future load on the semiconductor (2) is ascertained from the load cycle, wherein the cooling power of the cooling apparatus (3) is increased before the occurrence of an increasing load, which is detected on the basis of the ascertained future load.

12. Method according to claim 11, wherein the cooling power is controlled to a maximum value at a time, so that when the load occurs, as it results from the previously ascertained future load on the semiconductor (2), it is operated within its permissible temperature range.

13. Method according to one of claims 1 to 12, wherein the cooling power is controlled in such a way that on average a cooling power of at least the nominal cooling capacity, in particular exactly the nominal cooling capacity, is obtained.

14. Power unit (1), having
- at least one semiconductor (2),
- a cooling apparatus (3) for cooling the at least one semiconductor (2) and
- a control unit (4),
wherein the cooling power of the cooling apparatus (3) is controllable,
**characterised in that** the control unit (4) is set up to control or regulate the cooling power of the cooling apparatus (3) by means of a method according to one of claims 1 to 13.

15. Power converter (10) with at least one power unit (1) according to claim 14.

## Revendications

1. Procédé de refroidissement d'au moins un semiconducteur (2), dans lequel on détermine la courbe en fonction du temps de la charge du semiconducteur pendant une durée pouvant être donnée à l'avance, dans lequel on commande ou on règle un dispositif (3) de refroidissement pour le refroidissement du au moins un semiconducteur (2) en fonction d'une alternance de charge du semiconducteur (2), qui provient de la détermination de la courbe en fonction du temps de la charge, **caractérisé en ce que** l'on commande ou l'on règle le dispositif (3) en fonction de la charge moyennée pendant la durée pouvant être donnée à l'avance.

2. Procédé suivant la revendication 1, dans lequel on mesure le courant passant dans le semiconducteur (2), dans lequel on détermine la charge du semiconducteur (2) à partir du courant passant dans le semiconducteur (2) et de la fréquence de commutation du semiconducteur (2).

3. Procédé suivant l'une des revendications 1 ou 2, dans lequel on commande le dispositif (3) de refroidissement, de manière à réduire l'amplitude de fluctuation de la température du semiconducteur (2).

4. Procédé suivant l'une des revendications 1 à 3, dans lequel on détermine une valeur (5) de référence à partir de l'alternance de charge, dans lequel on commande la puissance de refroidissement du dispositif (3) de refroidissement en fonction de la différence entre la charge instantanée du semiconducteur (2) et la valeur (5) de référence.

5. Procédé suivant la revendication 4, dans lequel si la différence entre la charge instantanée du semiconducteur (2) et la valeur (5) de référence est positive, on augmente la puissance de refroidissement du dispositif de refroidissement et si la différence entre la charge instantanée du semiconducteur (2) et la valeur (5) de référence est négative, on réduit la puissance de refroidissement du dispositif (3) de refroidissement à une vitesse de variation donnée à l'avance.

6. Procédé suivant l'une des revendications 4 ou 5, dans lequel on détermine la valeur (5) de référence en formant une valeur moyenne, en particulier en formant une valeur moyenne pondérée ou en lissant la charge instantanée.

7. Procédé suivant la revendication 6, dans lequel pour une alternance de charge récurrente, on forme une valeur moyenne sur la période de la charge récurrente ou le lissage avec une constante de temps dans la plage de la période.

8. Procédé suivant l'une des revendications 1 à 7, dans lequel le dispositif (3) de refroidissement est constitué sous la forme d'un refroidissement par de l'air et l'augmentation de la puissance de refroidissement s'effectue par une augmentation d'une vitesse de rotation d'un ventilateur.

9. Procédé suivant l'une des revendications 1 à 7, dans lequel le dispositif (3) de refroidissement est constitué sous la forme d'un refroidissement par du liquide et l'augmentation de la puissance de refroidissement s'effectue par une augmentation d'un débit de fluide de refroidissement et/ou par un abaissement de la température du fluide de refroidissement.

10. Procédé suivant l'une des revendications 1 à 9, dans lequel à partir de l'alternance de charge, on détermine la charge minimum et la charge maximum du semiconducteur (2), dans lequel on commande la puissance de refroidissement dans la plage de 0 à 20 % de la puissance de refroidissement nominale si la charge instantanée du semiconducteur atteint la charge minimum et on commande la puissance de refroidissement dans la plage de 100 à 200 % de la puissance de refroidissement nominale, si la charge instantanée du semiconducteur (2) atteint la charge maximum.

11. Procédé suivant l'une des revendications 1 à 10, dans lequel à partir de l'alternance de charge, on détermine une charge à venir du semiconducteur (2), dans lequel avant l'apparition d'une charge croissante que l'on identifie, à l'aide de la détermination de la charge à venir, on augmente la puissance de refroidissement du dispositif (3) de refroidissement.

12. Procédé suivant la revendication 11, dans lequel on commande la puissance de refroidissement à une valeur maximum à un instant de manière à ce que, à l'apparition de la charge telle qu'elle provient de la détermination auparavant de la charge à venir du semiconducteur (2), on le fait fonctionner dans sa plage de température admissible.

13. Procédé suivant l'une des revendications 1 à 12, dans lequel on commande la puissance de refroidissement, de manière à obtenir en moyenne une puissance de refroidissement d'au moins la puissance de refroidissement nominale, en particulier exactement la puissance de refroidissement nominale.

14. Unité (1) de puissance, comportant
- au moins un semiconducteur (2),
- un dispositif (3) de refroidissement pour le refroidissement du au moins un semiconducteur (2) et
- une unité (4) de commande,
dans laquelle la puissance de refroidissement du dispositif (3) de refroidissement peut être commandée,
**caractérisée en ce que** l'unité (4) de commande est agencée pour commander ou réguler la puissance de refroidissement du dispositif (3) de refroidissement au moyen d'un procédé suivant l'une des revendications 1 à 13.

15. Convertisseur (10) ayant au moins une unité (1) de puissance suivant la revendication 14.
